# EUROPÄISCHE PATENTSCHRIFT

(11) **EP 1 855 319 B1**
(45) Veröffentlichungstag und Bekanntmachung des Hinweises auf die Patenterteilung: **21.12.2016**
(21) Anmeldenummer: 07008820.8
(22) Anmeldetag: 02.05.2007
(51) Int. Cl.: H01L 25/16, H01L 25/07, H05K 1/14, H01L 23/00

(54) **Leistungshalbleitermodul**
Power semiconductor device
Module semi-conducteur à haute puissance

(30) Priorität: 09.05.2006 DE 102006021412
(43) Veröffentlichungstag der Anmeldung: 14.11.2007
(73) Patentinhaber: Semikron Elektronik GmbH & Co. KG Patentabteilung, 90431 Nürnberg (DE)
(72) Erfinder: Popp, Rainer, 91580 Petersaurach (DE); Lederer, Marco, 90453 Nürnberg (DE)

(56) Entgegenhaltungen:
- DE-A1- 4 031 051
- DE-A1- 10 306 643
- DE-A1- 10 340 297
- DE-A1- 19 700 963
- DE-A1- 19 727 548
- DE-A1- 19 735 071
- DE-A1-102004 021 122
- DE-A1-102004 037 656
- DE-B3- 10 316 355

## Beschreibung

Die Erfindung betrifft ein Leistungshalbleitermodul mit einem elektrisch isolierenden Substrat zur Anordnung mit einer Leiterplatte, die vom Substrat durch ein Gehäuse beabstandet ist, wobei auf der der Leiterplatte zugewandten Innenseite des Substrates erste Leiterbahnen und an diesen ersten Leiterbahnen Leistungshalbleiterbauelemente kontaktiert sind, die durch ein Steuer-IC-Bauelement ansteuerbar sind, auf der dem Substrat zugewandten Innenseite der Leiterplatte zweite Leiterbahnen vorgesehen sind, und im Gehäuse zwischen den ersten und den zweiten Leiterbahnen federnde Verbindungselemente druckkontaktiert sind.

Derartige Leistungshalbleitermodule sind beispielsweise aus der DE 10 2004 021 122 A1, der DE 103 06 643 B4 oder aus der DE 103 16 355 B3 der Anmelderin bekannt. Bei diesen bekannten Leistungshalbleitermodulen sind die Steuer-IC-Bauelemente zum Ansteuern der am Substrat vorgesehenen Leistungshalbleiterbauelemente an der Leiterplatte vorgesehen. Bei dieser Leiterplatte handelt es sich um eine sogenannte Kundenplatine, d.h. bei diesen bekannten Leistungshalbleitermodulen sind die Steuer-IC-Bauelemente für die am Substrat vorgesehenen Leistungshalbleiterbauelemente an der Kundenplatine realisiert. Bei diesen bekannten Leistungshalbleitermodulen mit den Leistungshalbleiterbauelementen am Substrat und den Steuer-IC-Bauelementen an der vom Substrat durch das Gehäuse beabstandeten Leiterplatte ergeben sich lange Verbindungen zwischen den Steuer-IC-Bauelementen und den zugehörigen Leistungshalbleiterbauelementen. Diese relativ langen Verbindungen bewirken, dass die elektromagnetische Verträglichkeit dieser bekannten Leistungshalbleitermodule noch Wünsche offen lässt, weil die Einkopplung elektromagnetischer Wellen in die besagten Verbindungen zu deren Länge proportional ist.

Der Erfindung liegt die Aufgabe zugrunde, ein Leistungshalbleitermodul der eingangs genannten Art zu schaffen, das im Vergleich zu den bekannten Leistungshalbleitermodulen der oben genannten Art einfach herstellbar ist, und bei dem gleichzeitig die elektromagnetische Verträglichkeit verbessert ist.

Diese Aufgabe wird bei einem Leistungshalbleitermodul der eingangs genannten Art erfindungsgemäß dadurch gelöst, dass an der Innenseite des Substrates zusätzlich zu den ersten Leiterbahnen für die Leistungshalbleiterbauelemente außerdem auch IC-Leiterbahnen und das Steuer-IC-Bauelement vorgesehen sind.

Bei dem Substrat handelt es sich um ein DCB (- direct copper bonding) - Substrat. Die IC-Leiterbahnen sind mittels zugehöriger federnder Verbindungselemente mit zugehörigen zweiten Leiterbahnen der Leiterplatte druckkontaktiert. Die federnden Verbindungselemente sind also sowohl für Lastanschlüsse als auch für Steueranschlüsse der Leistungshalbleiterbauelemente vorgesehen.

Dadurch, dass an der Innenseite des Substrates nicht nur die Leistungshalbleiterbauelemente sondern auch das Steuer-IC-Bauelement vorgesehen und mit den Leistungshalbleiterbauelementen kontaktiert ist, ergeben sich relativ kurze Verbindungen zwischen den Leistungshalbleiterbauelementen und dem Steuer-IC-Bauelement, so dass die elektromagnetische Verträglichkeit des erfindungsgemäßen Leistungshalbleitermoduls entsprechend verbessert ist.

Ein weiterer Vorteil des erfindungsgemäßen Leistungshalbleitermoduls besteht darin, dass seine Herstellung vereinfacht ist, weil die Kontaktierung der Leistungshalbleiterbauelemente und des für diese vorgesehenen Steuer-IC-Bauelementes in der gleichen Ebene, nämlich auf der der Leiterplatte zugewandten Innenseite des Substrates erfolgt.

Bei dem erfindungsgemäßen Leistungshalbleitermodul ist das Steuer-IC-Bauelement mit den zugehörigen IC-Leiterbahnen vorzugsweise durch Bonddrähte kontaktiert. Nachdem auch die Leistungshalbleiterbauelemente mit den zugehörigen ersten Leiterbahnen durch Bonddrähte kontaktiert sind, ist es erfindungsgemäß mit einer Bondmaschine in einem Arbeitsgang möglich, sowohl die Leistungshalbleiterbauelemente als auch das für diese vorgesehene Steuer-IC-Bauelement mit den jeweils zugehörigen Leiterbahnen des Substrates zu kontaktieren. Das ist zeitsparend möglich, was sich auf die Produktivität der Herstellung des erfindungsgemäßen Leistungshalbleitermoduls positiv auswirkt.

Bei dem erfindungsgemäßen Leistungshalbleitermodul kann das Steuer-IC-Bauelement ein gehäuseloses Bauelement sein. Ein solches gehäuseloses ChipBauelement kann ohne weiteres mit den zugehörigen Leiterbahnen des Substrats mittels Bonddrähten kontaktiert werden. Eine andere Möglichkeit besteht darin, dass das Steuer-IC-Bauelement ein Gehäusebauelement ist. Bei einem solchen Gehäusebauelement handelt es sich beispielsweise um ein SMD-Bauelement.

Weitere Einzelheiten, Merkmale und Vorteile ergeben sich aus der nachfolgenden Beschreibung eines in der Zeichnung verdeutlichten Ausführungsbeispieles des erfindungsgemäßen Leistungshalbleitermoduls in einem vergrößerten Maßstab.

Es zeigen:
- Figur 1: einen Schnitt durch das Leistungshalbleitermodul, und
- Figur 2: eine Draufsicht auf das Substrat mit den ersten Leitungsbahnen, den Leistungshalbleiterbauelementen und dem Steuer-IC-Bauelement.

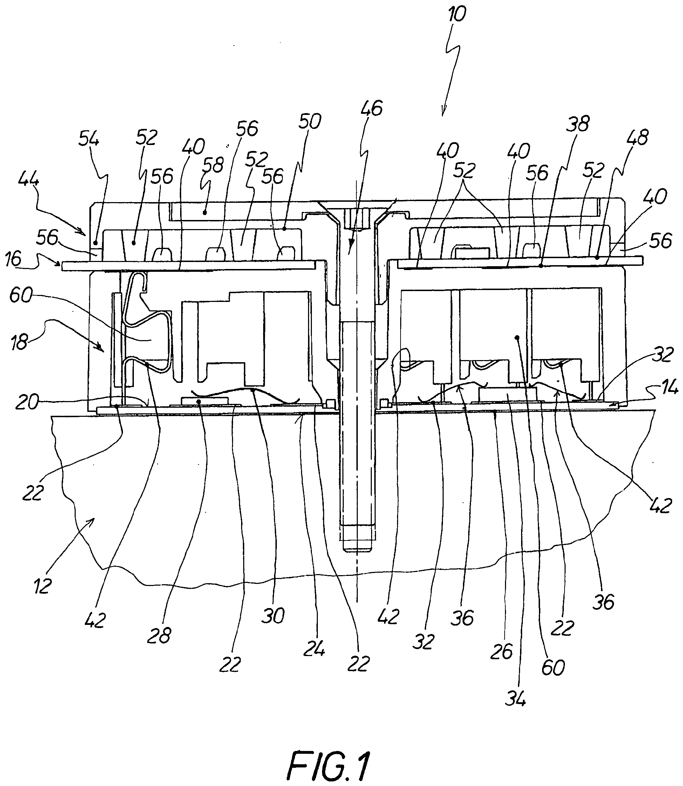

Figur 1 zeigt in einer Schnittdarstellung eine Ausbildung des Leistungshalbleitermoduls 10, das zur direkten Montage an einem abschnittweise gezeichneten Kühlkörper 12 vorgesehen ist. Das Leistungshalbleitermodul 10 weist ein elektrisch isolierendes Substrat 14 und eine Leiterplatte 16 auf, die vom Substrat 14 durch ein Gehäuse 18 beabstandet ist.

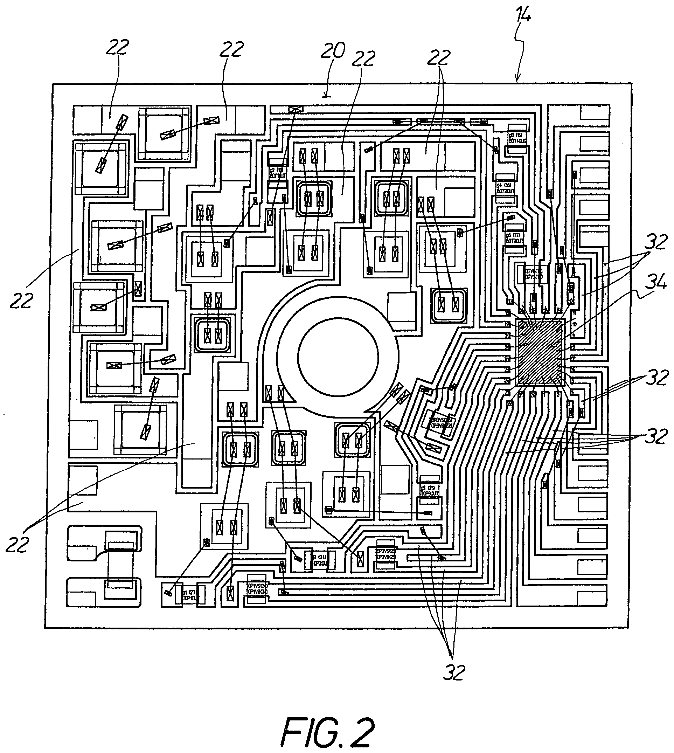

Wie auch aus Figur 2 ersichtlich ist, weist das elektrisch isolierende Substrat 14 auf seiner der Leiterplatte 16 zugewandten Innenseite 20 erste Leiterbahnen 22 auf. An der der Innenseite 20 gegenüberliegenden Außenseite 24 ist das elektrisch leitende Substrat 14 mit einer Metallschicht 26 versehen, um das elektrisch isolierende Substrat 14 wärmetechnisch an den Kühlkörper 12 anzukoppeln.

An der Innenseite 20 des Substrates 14 sind Leistungshalbleiterbauelemente 28 angeordnet, die jeweils mit zugehörigen ersten Leiterbahnen 22 kontaktiert sind. Diese Kontaktierung erfolgt durch Bonddrähte 30.

Wie insbesondere aus Figur 2 deutlich ersichtlich ist, sind an der Innenseite 20 des elektrisch isolierenden Substrates 14 zusätzlich zu den ersten Leiterbahnen 22 außerdem auch IC-Leiterbahnen 32 vorgesehen. Diese IC-Leiterbahnen 32 sind für ein Steuer-IC-Bauelement 34 vorgesehen, das mit den IC-Leiterbahnen 32 durch Bonddrähte 36 kontaktiert ist (siehe Figur 1).

Die Leiterplatte 16 des Leistungshalbleitermoduls 10 weist auf der dem Substrat 14 zugewandten Innenseite 38 zweite Leiterbahnen 40 auf. Die ersten Leiterbahnen 22 an der Innenseite 20 des elektrisch isolierenden Substrates 14 sind mit den zweiten Leiterbahnen 40 an der Innenseite 38 der Leiterplatte 16 durch federnde Verbindungselemente 42 druckkontaktiert. Diese Druckkontaktierung erfolgt mit Hilfe eines formstabilen Druckkörpers 44, der mittels eines mit dem Kühlkörper 12 verschraubten Schraubelementes 46 gegen die Außenseite 48 der Leiterplatte 16 gezwängt ist. Zu diesem Zwecke ist der Druckkörper 44 an seiner der Leiterplatte 16 zugewandten Innenseite 50 mit Druckorganen 52 und mit einem umlaufenden Kragen 54 ausgebildet. Der umlaufende Kragen 54 ist mit voneinander beabstandeten Aussparungen 56 ausgebildet, durch die hindurch eine kühlende Luftströmung möglich ist.

Der formstabile Druckkörper 44 ist mit einer die Formstabilität erhöhenden Metallseele 58 kombiniert.

Das Gehäuse 18 ist mit schlitzförmigen Führungskanälen 60 für die federnden Verbindungselemente 42 ausgebildet.

### Bezugsziffernliste:

- 10: Leistungshalbleitermodul
- 12: Kühlkörper (für 10)
- 14: elektrisch isolierendes Substrat (von 10)
- 16: Leiterplatte (von 10)
- 18: Gehäuse (von 10 zwischen 14 und 16)
- 20: Innenseite (von 14)
- 22: erste Leiterbahnen (an 20)
- 24: Außenseite (von 14)
- 26: Metallschicht (an 24)
- 28: Leistungshalbleiterbauelemente (an 20)
- 30: Bonddrähte (zwischen 28 und 22)
- 32: IC-Leiterbahnen (an 20)
- 34: Steuer-IC-Bauelement (an 20)
- 36: Bonddrähte (zwischen 34 und 32)
- 38: Innenseite (von 16)
- 40: zweite Leiterbahnen (an 38)
- 42: federnde Verbindungselemente (zwischen 22 und 40)
- 44: formstabiler Druckkörper (für 10)
- 46: Schraubelement (zwischen 44 und 12)
- 48: Außenseite (von 16)
- 50: Innenseite (von 44)
- 52: Druckorgane (von 44 zwischen 50 und 48)
- 54: umlaufender Kragen (von 44)
- 56: Aussparungen (in 54)
- 58: Metallseele (von 44)
- 60: schlitzförmige Führungskanäle (von 18 für 42)

## Patentansprüche

1. Leistungshalbleitermodul mit einem elektrisch isolierenden DCB- Substrat (14) zur Anordnung mit einer Leiterplatte (16), die vom Substrat (14) durch ein Gehäuse (18) beabstandet ist, wobei auf der der Leiterplatte (16) zugewandten Innenseite (20) des Substrates (14) erste Leiterbahnen (22) und an diesen Leistungshalbleiterbauelemente (28) kontaktiert sind, die durch ein Steuer-IC-Bauelement (34) ansteuerbar sind, auf der dem Substrat (14) zugewandten Innenseite (38) der Leiterplatte (16) zweite Leiterbahnen (40) vorgesehen sind, und im Gehäuse (18) zwischen den ersten und den zweiten Leiterbahnen (22 und 40) federnde Verbindungselemente (42) druckkontaktiert sind,
**dadurch gekennzeichnet,**
**dass** an der Innenseite (20) des Substrates (14) zusätzlich zu den ersten Leiterbahnen (22) auch IC-Leiterbahnen (32) und das Steuer-IC-Bauelement (34) vorgesehen sind, diese IC-Leiterbahnen (32) mittels zugehöriger federnder Verbindungselemente (42) mit der zugehörigen zweiten Leiterbahnen (22) der Leiterplatte (16) druckkontaktiert verbunden sind und hierzu die federnden Verbindungselemente (42) sowohl für Lastanschlüsse als auch für Steueranschlüsse der Leistungshalbleiterbauelemente (28) als auch des Steuer-IC-Bauelements (34) vorgesehen sind.

2. Leistungshalbleitermodul nach Anspruch 1,
**dadurch gekennzeichnet,**
**dass** das Steuer-IC-Bauelement (34) mit den zugehörigen IC-Leiterbahnen (32) durch Bonddrähte (36) kontaktiert ist.

3. Leistungshalbleitermodul nach Anspruch 1 oder 2,
**dadurch gekennzeichnet,**
**dass** das Steuer-IC-Bauelement (34) ein gehäuseloses Chipbauelement ist.

4. Leistungshalbleitermodul nach Anspruch 1 oder 2,
**dadurch gekennzeichnet,**
**dass** das Steuer-IC-Bauelement (34) ein Gehäusebauelement ist.

5. Leistungshalbleitermodul nach Anspruch 1 bis 4,
**dadurch gekennzeichnet,**
**dass** die federnden Verbindungselemente (42) mittels eines formstabilen Druckkörpers (44) druckkontaktiert sind.

## Claims

1. Power semiconductor module having an electrically insulating DCB substrate (14) for arrangement with a printed circuit board (16), which is spaced apart from the substrate (14) by a housing (18), wherein on the inner side (20) of the substrate (14), which faces the printed circuit board (16), first conductor tracks (22) and thereon power semiconductor devices (28) are contacted, which are drivable by a control IC device (34), second conductor tracks (40) are provided on the inner side (38) of the printed circuit board (16), which faces the substrate (14), and spring-mounted connecting elements (42) are pressure-contacted in the housing (18) between the first and the second conductor tracks (22 and 40), **characterized in that**, in addition to the first conductor tracks (22), IC conductor tracks (32) and the control IC device (34) are provided on the inner side (20) of the substrate (14), said IC conductor tracks (32) are connected in a pressure-contacted manner to the associated second conductor tracks (22) of the printed circuit board (16) by means of associated spring-mounted connecting elements (42), and to this end the spring-mounted connecting elements (42) are provided both for load connections and for control connections of the power semiconductor devices (28) and also of the control IC device (34).

2. Power semiconductor module according to Claim 1, **characterized in that** the control IC device (34) is contacted with the associated IC conductor tracks (32) by way of bond wires (36).

3. Power semiconductor module according to Claim 1 or 2, **characterized in that** the control IC device (34) is a housingless chip device.

4. Power semiconductor module according to Claim 1 or 2, **characterized in that** the control IC device (34) is a housing device.

5. Power semiconductor module according to Claim 1 to 4, **characterized in that** the spring-mounted connecting elements (42) are pressure-contacted by means of a dimensionally stable pressure body (44).

## Revendications

1. Module à semiconducteur de puissance comprenant un substrat DCB (14) électriquement isolé destiné à être monté avec un circuit imprimé (16) qui est espacé du substrat (14) par un boîtier (18), des premières pistes conductrices (22) se trouvant sur le côté intérieur (20) du substrat (14) faisant face au circuit imprimé (16) et des composants semiconducteurs de puissance (28), qui peuvent être pilotés par un composant CI de commande (34), étant en contact avec celles-ci, des deuxièmes pistes conductrices (40) se trouvant sur le côté intérieur (38) du circuit imprimé (16) faisant face au substrat (14) et des éléments de liaison à ressort (42) étant en contact par pression dans le boîtier (18) entre les premières et les deuxièmes pistes conductrices (22 et 40),
**caractérisé en ce**
**que** des pistes conductrices de CI (32) et le composant CI de commande (34) se trouvent sur le côté intérieur (20) du substrat (14) en plus des premières pistes conductrices (22),
ces pistes conductrices de CI (32) sont reliées par mise en contact par pression au moyen d'éléments de liaison à ressort (42) associés avec les deuxièmes pistes conductrices (22) correspondantes du circuit imprimé (16) et les éléments de liaison à ressort (42) étant prévus à cet effet à la fois pour les connexions de charge et les connexions de commande des composants semiconducteurs de puissance (28) ainsi que du composant CI de commande (34).

2. Module à semiconducteur de puissance selon la revendication 1, **caractérisé en ce que** le composant CI de commande (34) est mis en contact avec les pistes conductrices de CI (32) associées par des fils de connexion (36).

3. Module à semiconducteur de puissance selon la revendication 1 ou 2, **caractérisé en ce que** le composant CI de commande (34) est un composant en puce sans boîtier.

4. Module à semiconducteur de puissance selon la revendication 1 ou 2, **caractérisé en ce que** le composant CI de commande (34) est un composant en boîtier.

5. Module à semiconducteur de puissance selon les revendications 1 à 4, **caractérisé en ce que** les éléments de liaison à ressort (42) sont mis en contact par pression au moyen d'un corps de compression (44) indéformable.
